# EUROPÄISCHE PATENTSCHRIFT

(11) **EP 1 243 168 B1**
(45) Veröffentlichungstag und Bekanntmachung des Hinweises auf die Patenterteilung: **09.07.2003**
(21) Anmeldenummer: 00962192.1
(22) Anmeldetag: 03.08.2000
(51) Int. Cl.: H05K 7/14

(54) **BETÄTIGUNGSELEMENT FÜR FLACHBAUGRUPPEN MIT EIN- UND/ODER AUSHEBELSTÜCK**
OPERATING ELEMENT WITH ON AND/OR OFF LEVER PIECE FOR PRINTED CIRCUIT BOARDS
ELEMENT D'ACTIONNEMENT POUR DES CARTES DE CIRCUITS IMPRIMES, COMPORTANT UN LEVIER D'INTRODUCTION ET/OU DE RETRAIT

(30) Priorität: 22.12.1999 DE 29922557 U
(43) Veröffentlichungstag der Anmeldung: 25.09.2002
(73) Patentinhaber: Rittal Electronic Systems GmbH & Co. KG, 90542 Eckental (DE)
(72) Erfinder: BEHRENS, Ralf, D-90419 Nürnberg (DE); KÖRBER, Werner, D-91282 Betzenstein (DE); KURRER, Siegfried, D-90449 Nürnberg (DE); SCHAFFER, Kurt-Michael, D-90542 Eckental (DE)
(74) Vertreter: Fleck, Hermann-Josef, Dr.-Ing.
(86) Internationale Anmeldenummer: DE0002601
(87) Internationale Veröffentlichungsnummer: WO01047331

(56) Entgegenhaltungen:
- EP-A- 0 313 270
- EP-A- 0 780 932
- WO-A-96/42187
- DE-A- 4 105 948
- DE-A- 4 309 973
- US-A- 4 699 594
- US-A- 5 669 512
- US-A- 5 810 613

## Beschreibung

Die Erfindung betrifft ein Betätigungselement, womit Flachbaugruppen, welche elektronische Schaltungen tragen, ohne großen Kraftaufwand in ein Trägersystem eingehebelt bzw. daraus wieder entnommen werden können. Derartige Betätigungselemente werden seit längerem eingesetzt und sind in unterschiedlichen Ausführungen bekannt. In der Europäischen Patentschrift EP 0 330 957 B1 ist beispielhaft eine weit verbreitete Ausführung für ein solches Betätigungselement dargestellt. Dieses wird als Steck- und Ziehhilfe bezeichnet, und ist Bestandteil eines Frontsystems für Steckbaugruppen, die in einen Baugruppenträger einschiebbar sind. Die Steck- und Ziehhilfe weist einen Hebel auf, der an einem Endstück drehbar gelagert ist. Eine Bedienpersonen kann die Steck- und Ziehhilfe über den Hebel betätigen und durch entsprechende Schwenkung eine Ein- bzw. Aushebelung der Steckbaugruppe bewirken. Zur Erzielung dieser Bewegungen weist der Hebel eine Nut auf, deren außenliegende Kanten als Nasen gestaltet sind. Diese stützen sich bei einer Ein- oder Aushebelbewegung an entsprechenden Kanten des Baugruppenträgers ab, insbesondere an Querverbindungsschienen des Baugruppenträgers.

In besondere Anwendungsfällen können insbesondere die an der Ein- und/oder Aushebelung einer Flachbaugruppe beteiligten Teile eines Betätigungselements einer besonderen Belastung ausgesetzt sein. Diese kann einerseits auf vielfach wiederholten Ein- und Aushebelvorgängen beruhen. Andererseits können besondere Belastungen auch dadurch entstehen, das bei einem Ein- bzw. Aushebelvorgang einer Flachbaugruppe besonders hohe Steck- bzw. Ziehkräfte überwunden werden müssen. Diese können von Steckverbindern herrühren, welche an einer Kante der Flachbaugruppe angebracht sind und eine hohen Anzahl an Kontaktpolen aufweist. Auf Grund der zunehmenden Integration elektronischer Bauelemente und der Zunahme der Bitbreiten von digitalen Datenbussen weisen die Polzahlen von Steckverbindern insbesondere an Flachbaugruppen, welche digitale Prozessoren tragen, steigende Werte auf.

Der Erfindung liegt die Aufgabe zugrunde, insbesondere ein Betätigungselement für Flachbaugruppen so weiter auszugestalten, dass dieses auch höheren Belastungen gewachsen ist.

Die Aufgaben wird gelöst mit dem in den Ansprüchen angegebenen Betätigungselement. Weitere vorteilhafte Ausführungsformen des Betätigungselements sind in den Unteransprüchen angegeben. Weitere Unteransprüche betreffen ein Verfahren zur Herstellung eines Betätigungselements, betreffen ferner ein Frontsystem für eine Flachbaugruppe, welche mit mindestens einem Betätigungselement gemäß der Erfindung ausgerüstet ist, betreffen ferner eine Flachbaugruppe mit einem entsprechenden Frontsystem, und betreffen schließlich einen Baugruppenträger mit einem entsprechenden Frontsystem.

Ein Betätigungselement gemäß der Erfindung weist ein Endstück auf, das zur Verbindung mit einer Flachbaugruppe vorbereitet ist, und einen Betätigungshebel, der drehbar an dem Endstück gelagert ist. Der Betätigungshebel weist wiederum ein Griffteil und ein Ein- und/oder Aushebelstück auf, welches zumindest teilweise aus einem verschleißfesten Material besteht.

Eine derartige Ausführung weist den besonderen Vorteil auf, dass dasjenige Teil des erfindungsgemäßen Betätigungselements, welches eine Ein- und/oder Aushebelung bewirkt, d.h. das Ein- und/oder Aushebelstück, gegenüber dem zur Bedienung vorgesehenen Teil des erfindungsgemäßen Betätigungselements, d.h. dem Griffteil, zumindest teilweise aus einem verschleißfesten Material besteht. Hiermit wird das gesamte Betätigungselement deutlich robuster gegenüber besonderen Beanspruchungen, ohne dass dabei Einbußen bei den Anforderungen an die Ergonomie des Griffteiles auftreten.

Es ist besonders vorteilhaft, wenn das Griffteil aus einem ergonomisch gut formbaren Material gefertigt ist, d.h. einem Material, womit ergonomische Gestaltungen des Griffteils herstellbar sind, d.h. für eine Person einfach, sicher und angenehm greifbare Formen und Oberflächen. Besonders vorteilhaft sind auch elastische Materialien für das Griffteil, z.B. gummiartige Materialien, womit zusätzlich zur Ergonomie auch weitere Anforderungen, wie z.B. Reduktion eines möglichen Verletzungsrisikos oder Anpassung an ungünstige Einbaubedingungen, erfüllt werden können.

Die Erfindung wird an Hand der nachfolgend kurz angegebenen Figuren näher erläutert. Dabei zeigt
- Figur 1:: eine Seitenansicht auf eine prinzipielle Ausführung eines Betätigungselementes gemäß der Erfindung,
- Figur 2:: in einer perspektivischen Seitenansicht ein Front-system für eine Flachbaugruppe mit einem ersten Ausführungsbeispiel eines erfindungsgemäßen Betätigungselementes in einer Explosionsdarstellung, und einen Ausschnitt eines Baugruppenträgers, wobei das Ein- und Aushebelstück vorteilhaft als ein Druckgussteil ausgeführt ist,
- Figur 3:: eine perspektivische Seitenansicht der wesentlichen Elemente eines Betätigungselementes gemäß der Erfindung in einer zweiten Ausführungsform, wobei das Ein- und Aushebelstück vorteilhaft als ein Blechbiegeteil ausgeführt ist,
- Figur 4:: eine perspektivische Seitenansicht der wesentlichen Elemente eines Betätigungselementes gemäß der Erfindung in einer dritten Ausführungsform, wobei das Ein- und Aushebelstück vorteilhaft zwei separaten Eingriffsteile aufweist,
- Figur 5:: eine perspektivische Seitenansicht der wesentlichen Elemente eines Betätigungselementes gemäß der Erfindung in einer vierten Ausführungsform, wobei das Ein- und Aushebelstück vorteilhaft zwei separate Eingriffsteile aufweist, welche über Haltezapfen mit dem Griffteil verbindbar sind,
- Figur 6:: eine perspektivische Seitenansicht des Betätigungs-elementes gemäß Figur 5 in einem zusammengefügten Zustand aller Teile,
- Figur 7:: eine Seitenansicht auf eine weitere Ausführung eines Betätigungselementes gemäß der Erfindung, wobei das Griffteil einen stark nach vorne ragenden Griffkopf aufweist,
- Figur 8:: eine Seitenansicht auf eine weitere Ausführung eines Betätigungselementes gemäß der Erfindung, wobei das Griffteil einen hoch stehenden Griffkopf aufweist, und
- Figur 9:: eine perspektivische Seitenansicht der wesentlichen Elemente eines Betätigungselementes gemäß der Erfindung in einer weiteren Ausführungsform, wobei das Ein- und Aushebelstück vorteilhaft ein Eingriffsteil mit einer t-förmig aufgesetzten Halteplatte aufweist.

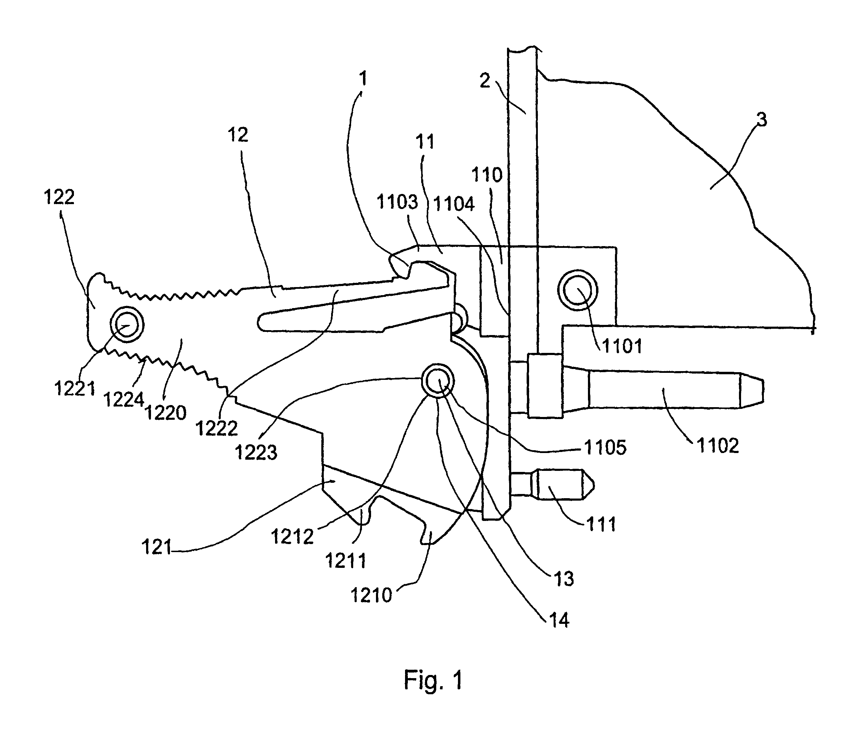

Figur 1 zeigt eine Seitenansicht auf eine prinzipielle Ausführung eines zum Ein- und/oder Aushebeln einer Flachbaugruppe dienenden Betätigungselementes 1 gemäß der Erfindung. Es weist als Grundelemente auf ein Endstück 11, welches zur Verbindung mit einer Flachbaugruppe vorbereitet ist, und einen Betätigungshebel 12, der drehbar am Endstück 11 gelagert ist.

Der Betätigungshebel 12 weist ein Ein- und/oder Aushebelstück 121 auf, welches zumindest teilweise aus einem verschleißfesten Material besteht, und ein Griffteil 122, das mit dem Einund/oder Aushebelstück 121 verbunden ist.

Das Endstück 11 des Betätigungselements 1 besteht im wesentlichen aus einem Tragkörper 110. Dieser weist eine Bohrung 1101 auf, welche zur Befestigung mit einer Leiterplatte z.B. über eine Schraube dienen kann. Das Endstück 11 verfügt desweiteren über einen Kontaktpin 1102, der bei Einschub einer mit einem entsprechenden Betätigungselement 1 versehenen Flachbaugruppe in einen Baugruppenträger eine Massekontaktierung zwischen den Elementen bewirkt. Zur Halterung einer in einen Baugruppenträger eingeschobenen Einheit z.B. aus einer Flachbaugruppe mit einem angebrachten Frontsystem, welches aus einer Frontplatte und bevorzugt zwei Betätigungselementen 1 an den Enden besteht, kann im Tragkörper 110 eine Halteschraube 111 vorgesehen sein. Vorteilhaft weist der Tragkörper 110 eine Bohrung 1105 auf. In diese kann eine Drehwelle 13 eingebracht werden, worüber der Betätigungshebel 12 drehbar am Tragkörper 110 gehalten werden kann. Ferner ist vorteilhaft eine Haltenut 1104 zum Einschub des unteren Endes einer ausschnittsweise dargestellten Frontplatte 2 vorhanden. Schließlich weist der Tragkörper 110 an einer dem Betätigungshebel 12 zugewandten Seite eine Rastnase 1103 auf. In diese kann eine entsprechende, bevorzugt federnde Rastlamellen 1222 des Betätigungshebels 12 eingreifen, wenn dieser sich in der eingerasteten Position befindet.

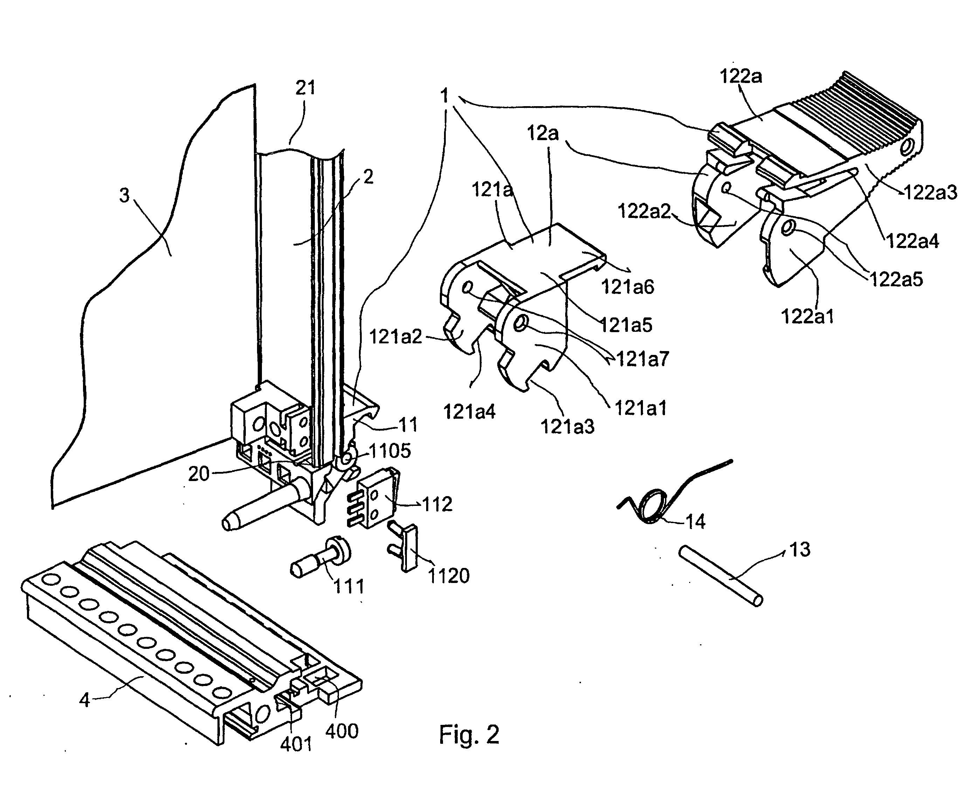

Ferner kann in das Endstück 11 des Betätigungselements 1 ein Mikroschalter 112 integriert sein. Ein derartiger ist in Figur 2 mit einem dazugehörigen Haltestopfen 1120 dargestellt. Die Funktion eines derartigen Mikroschalters 112 ist im Europäischen Patent EP 0 832 547 beschrieben.

Der im Beispiel der Figur 1 dargestellte Betätigungshebel 12 des Betätigungselements 1 weist erfindungsgemäß ein Griffteil 122 und ein Ein- und/oder Aushebelstück 121 auf. Dabei weist das Griffteil 122 eine Bohrung 1223, das Ein- und/oder Aushebelstück 121 eine Bohrung 1212 und das Endstück 11 eine Bohrung 1105 auf. Eine Drehwelle 13 kann durch alle Bohrungen so hindurch geführt werden, dass der Betätigungshebel 12 drehbar am Endstück 11 gelagert ist. Mit Hilfe der Drehung kann eine Einhebelung einer mit dem Endstück verbundenen Flachbaugruppe 3 in einen Baugruppenträger bzw. eine Aushebelung aus dem Baugruppenträger bewirkt werden.

Das Griffteil 122 weist einen Griffkopf 1220 auf, der einen händischen Zugriff einer Bedienperson ermöglicht. Eine zusätzliche Oberflächenrippung 1224 verbessert die Sicherheit der Handhabung. Mittels der zusätzlichen Querbohrung 1221 am vorderen Ende des Griffkopfes 1220 können nebeneinander liegende Griffteile 122 von mehreren Betätigungselementen, die an verschiedenen Flachbaugruppen angebracht sind, mechanisch so miteinander verbunden werden, dass eine synchrone Bewegung derselben möglich ist. Figur 1 zeigt das Griffteil 122 in einer Position, welche dem in einen Baugruppenträger eingehebelten Zustand der Flachbaugruppe 3 entspricht. Zusätzlich ist das Griffteil 122 mit dem Endstück 11 in dieser Position mit Hilfe von Verrastmitteln verrastet, in dem eine federnde Rastlamelle 1222 des Griffteils 122 eine Rastnase 1103 des Endstücks 11 hintergreift. Über eine integrierte, in Figur 1 nicht dargestellte Rückstellfeder 14 wird der Betätigungshebel 12 in die in Figur 1 dargestellte Ruheposition zurück bewegt, wenn keine nach unten gerichtete Kraft auf das Griffteil 122 ausgeübt wird.

Bei dem in Figur 1 dargestellten Beispiel ist das Einund/oder Aushebelstück 121 in das Griffteil 122 eingelegt, dieses umfaßt das Ein- und/oder Aushebelstück 121 quasi von oben. Desweiteren weist das Ein- und/oder Aushebelstück 121 im dargestellten Beispiel sowohl eine Einhebelnase 1210 als auch eine Aushebelnase 1211 auf, wobei zumindest diese Teile aus einem verschleißfesten Material bestehen. Über den Betätigungshebel 12 kann somit sowohl eine Einhebelung als auch eine Aushebelung der Flachbaugruppe 3 bewirkt werden. Bei anderen Ausführungsformen ist es auch möglich, dass ein Einund/oder Aushebelstück 121 so ausgeführt ist, dass damit nur eine Einhebelung oder eine Aushebelung bewirkbar ist. Bei dem Beispiel von Figur 1 kann dies bedeuten, dass nur eine Einhebelnase 1210 oder nur eine Aushebelnase 1211 vorhanden ist.

Der Vorteil der erfindungsgemäßen Ausführung des Betätigungselements 1 besteht darin, dass nur die bei Ein- und/oder Aushebelvorgängen besonders belasteten Teile des Betätigungshebels 12, d.h. das Ein- und/oder Aushebelstück 121, aus einem verschleißfesten Material bestehen, während alle übrigen Tei1e, insbesondere das Griffteil 122, aus leichter form- und gestaltbaren Materialien, insbesondere aus einem Kunststoff bestehen können. Bevorzugt kann das Material so ausgewählt werden, dass es ergonomisch gut formbar ist. In einer anderen Ausführung kann das Griffteil 122 des Betätigungshebels 12 aus einem elastischen Material besteht, insbesondere aus Gummi oder einem anderen Elastomer.

Wie bereits erläutert, sind bei dem in Figur 1 dargestellten Beispiel alle Teile des Betätigungselements 1 über eine gemeinsame Drehwelle 13 miteinander verbunden. Bei einer anderen Ausführung des Betätigungselements 1 können das Griffteil 122 und das Ein- und/oder Aushebelstück 121 des Betätigungshebels 12 auch nicht lösbar miteinander verbunden sein. Vorteilhaft können das Griffteil 122 und das Ein- und/oder Aushebelstück 121 auch einstückig verbunden sein. Es ist auch besonders vorteilhaft, wenn das Griffteil 122 des Betätigungselements 1 einstückig an das Ein- und/oder Aushebelstück angeformt wird, insbesondere angespritzt wird. Hierfür eignet sich wiederum besonders vorteilhaft ein elastomeres Material.

Figur 2 zeigt in einer perspektivischen Seitenansicht eine Explosionsdarstellung eines Frontsystems gemäß der Erfindung für eine Flachbaugruppe 3 mit einem weiteren Ausführungsbeispiel eines erfindungsgemäßen Betätigungselements 1a. Ferner ist ein Baugruppenträger ausschnittsweise dargestellt. Der Ausschnitt zeigt einen Bereich einer unteren Querverbindungsschiene 4, welche eine Reihe von Eingriffslöchern 400 aufweist. In bzw. an diese greifen die aus einem verschleißfesten Material bestehenden Ein- und Aushebelnasen 121a3,121a4 ein, wenn die Flachbaugruppe 3 bei einer Betätigung des Betätigungshebels 12a ein- bzw. ausgehebelt wird. Dabei stützen sich die Aushebelnasen 121a4 an der Außenseite der Querverbindungsschiene 4 ab, während die Einhebelnasen 121a3 sich im Inneren der Eingriffslöchern 400 abstützen. Ferner weist der in Figur 2 gezeigte Ausschnitt einer Querverbindungsschiene 4 eines Baugruppenträgers eine Quernut 401 auf. In diese kann eine Halteschraube 111 zur Fixierung der Frontplatte eingeschraubt werden.

Das in Figur 2 dargestellte Frontsystem für die Flachbaugruppe 3 weist eine ausschnittsweise gezeigte Frontplatte 2 auf. An deren unterem Ende 20 ist ein Betätigungselement 1a angebracht. In der Regel ist ein entsprechendes Betätigungselement auch an dem oberen Ende 21 der Frontplatte 2 angebracht, welche in Figur 2 nicht dargestellt ist. Das Frontsystem ist an einer ebenfalls ausschnittsweise dargestellten Flachbaugruppe 3 angebracht. Das Betätigungselementes 1a von Figur 2 weist auf ein Endstück 11, welches der Ausführung von Figur 1 entspricht, und einen Betätigungshebel 12a aus einem Einund/oder Aushebelstück 121a und einem Griffstück 122a. Mit Hilfe des Frontsystems ist die Flachbaugruppe 3 in einen Baugruppenträger ein- und/oder aushebelbar, wobei dieser zumindest eine entsprechende Querverbindungsschiene 4 aufweisen.

Das Griffteil 121a des Betätigungselements 1a besteht beispielhaft aus Kunststoff, und weist einen vorspringenden Griffkopf 122a3 auf, von dem nach unten eine erste und zweite Flanke 122a1, 122a2 abgehen. Hiermit kann die Verbindung des Griffteils 122a mit dem Ein- und/oder Aushebelstück 121a erleichtert werden, indem die seitlichen Flanken 122a1,122a2 das Ein- und/oder Aushebelstück 121a zur besseren Führung umfassen, wenn das Griffteil 121a auf das Ein- und/oder Aushebelstück 121a aufgelegt, bzw. das Ein- und/oder Aushebelstück 121a in das Griffteil 122a eingelegt wird. Über die Bohrungen 122a5 kann wiederum eine Drehwelle 13 zur Verbindung aller Teile eingeführt werden. Das Griffteil 121a weist ebenfalls eine federnde Rastlamellen 122a4 auf.

Das in Figur 2 dargestellte Ein- und/oder Aushebelstück 121a des Betätigungselements 1a weist zwei nebeneinander angeordnete Eingriffsteile 121a1 und 121a2 auf. Jedes dieser Eingriffsteile verfügt über eine separate Gruppe von Ein- und Aushebelnasen 121a3,121a4. Im Beispiel der Figur 2 sind die beiden Eingriffsteile 121a1,121a2 vorteilhaft über ein Verbindungsteil 121a5 einstückig miteinander verbunden. Das Verbindungsteil weist als eine Verlängerung ein Haltemesser 121a6 auf, welches beim Aufsetzen des Griffteils 122a in den Raum zwischen den Flanken 122a1,122a2 eintaucht und dort über möglicherweise zusätzlich vorhandene Elemente gehalten werden kann. Das Ein- und/oder Aushebelstück 121a von Figur 2 stellt vorteilhaft ein Druckgussteil insbesondere aus Aluminium und/oder Zink dar. Auch die Eingriffsteile 121a1,121a2 weisen Bohrungen 121a7 für den Eingriff einer Drehwelle 13 auf.

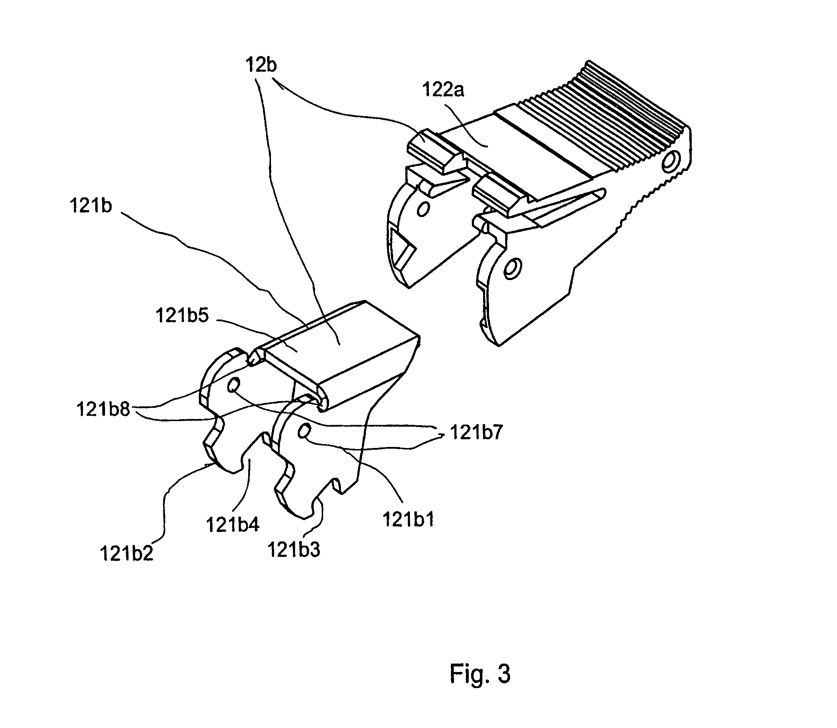

Figur 3 zeigt eine perspektivische Seitenansicht der wesentlichen Elemente eines Betätigungshebels 12b für ein erfindungsgemäßes Betätigungselement in einer weiteren Ausführungsform. Dabei weist das dazugehörige Ein- und Aushebelstück 121b wiederum ein erstes und ein zweites Eingriffsteil 121b1, 121b2 auf. Diese sind annähernd parallel nebeneinander liegend angeordnet. Jedes Eingriffsteil 121b1 bzw. 121b2 verfügt jeweils über eine vollständige Gruppe 121b3 bzw. 121b4 von Ein- und Aushebelnasen. Die Eingriffsteile weisen jeweils eine Bohrungen 121b7 für eine Drehwelle auf, womit Ein- und Aushebelstück 121b mit dem Griffteil 122a und einem Endstück 11 zu einem Betätigungselement verbindbar sind. Das Griffteil 122a entspricht weitgehend der bereits am Beispiel der Figur 2 erläuterten Ausführung.

Im Beispiel der Figur 3 ist das Ein- und Aushebelstück 121b vorteilhaft als ein Stanzbiegeteil insbesondere aus Blech ausgeführt. Die Gesamtanordnung aus den parallelen Eingriffsteilen 121b1,121b2 und einem Verbindungsrücken 121b5, der diese einstückig verbindet entsteht dabei aus einem ursprünglich ebenen Blechstanzteil, welches durch entsprechende Biegungen in die U-förmige Struktur von Figur 3 gebracht wurde. Bei einer solchen Ausführung treten üblicherweise Materialwölbungen 121b8 an den Übergängen zwischen den Eingriffsteilen 121b1,121b2 und dem Verbindungsrücken 121b5 auf. Diese können vorteilhaft genutzt werden, um die Fixierung des Ein- und Aushebelstücks 121b im Griffteil 122a nach einer Auflage desselben zu verbessern.

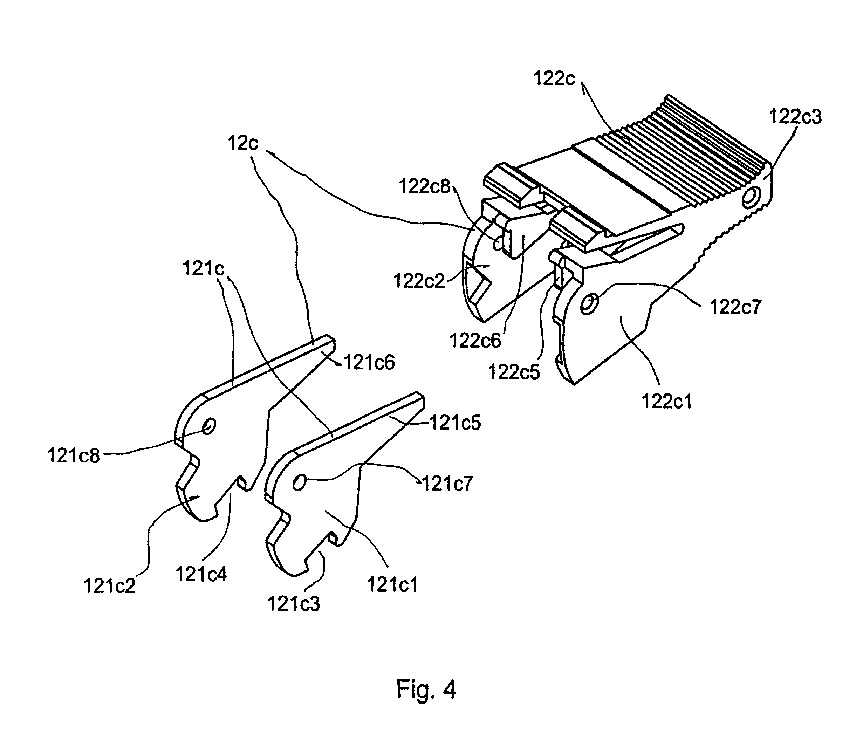

Figur 4 zeigt eine perspektivische Seitenansicht der wesentlichen Elemente eines Betätigungshebels 12c für ein erfindungsgemäßes Betätigungselement in einer weiteren Ausführungsform. Das Ein- und Aushebelstück 121c besteht dabei vorteilhaft aus zwei separaten Eingriffsteilen 121c1,121c2, die wiederum jeweils eine getrennte Gruppe 121c3,121c4 von Einund Aushebelnasen aufweisen. Vorteilhaft sind die Eingriffsteile 121c1,121c2 beispielhaft als Blechstanzteile ausgeführt. Damit diese annähernd parallel nebeneinander liegend positionierbar sind, weist jedes Eingriffsteil 121c1 bzw. 121c2 eine Verlängerung in Form eines Klemmstegs 121c5 bzw. 121c6 auf. Zu deren Halterung weist das dazugehörige Griffteil 122c entsprechende Haltemittel 122c5,122c6 auf. Im Beispiel der Figur 4 sind diese in Form von Klemmblöcken 122c5,122c6 ausgeführt und auf den Innenseiten einer ersten und zweiten Flanke 122c1,122c2 des Griffteils 122c angebracht. Die Klemmstege 121c5,121c6 der Eingriffsteile 121c1, 121c2 können messerartig in Aufnahmeräume eingeschoben werden, welche zwischen den Innenseiten der jeweiligen Flanke und den jeweiligen Klemmblöcken auf der Unterseite des vorspringenden Griffkopfs 122c3 des Griffteils 122c gebildet sind. Hiermit kann aucn ohne Zuhilfenahme einer Drehwelle das Ein- und Aushebelstück 121c mit dem Griffteil 122c zu dem Betätigungshebel 12c verbunden werden. Im Beispiel der Figur 4 weisen dennoch einerseits die Eingriffsteile 121c1,121c2 Bohrungen 121c7,121c8 und andererseits die Flanken 122c1,122c2 des Griffteils 122c Bohrungen 122c7,122c8 für eine Drehwelle auf. hiermit kann der gesamte Betätigungshebel 12c an einem Endstück 11 fixiert werden.

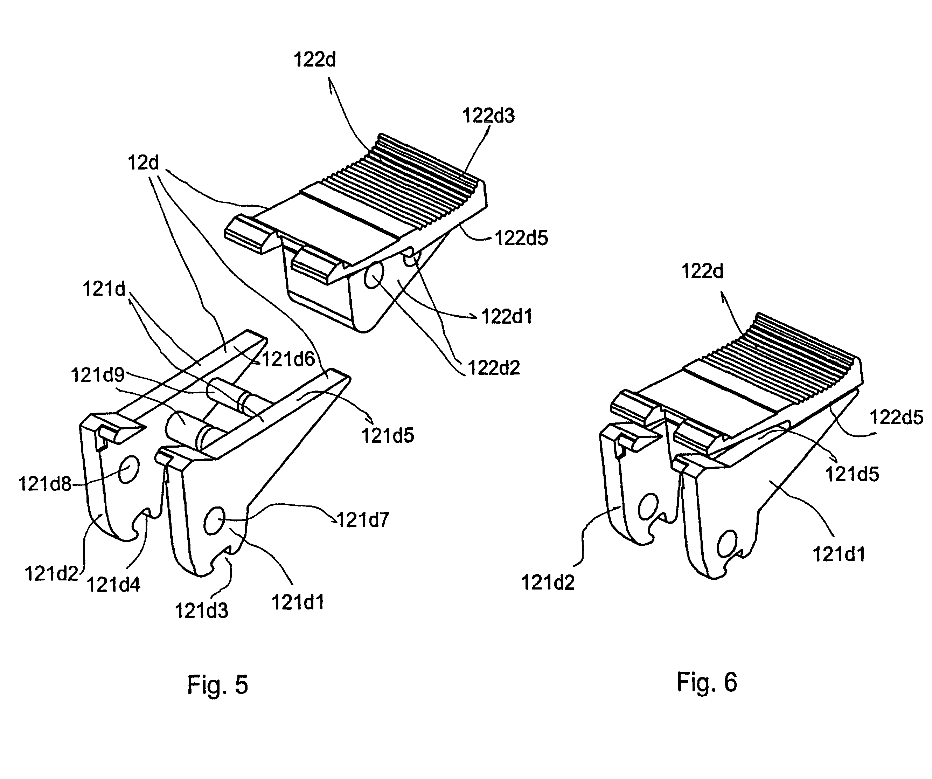

Figur 5 zeigt eine perspektivische Seitenansicht der wesentlichen Elemente eines Betätigungshebels 12d für ein Betätigungselement gemäß einer weiteren Ausführungsform. Dabei weist das Ein- und Aushebelstück 121d wiederum zwei separate Eingriffsteile 121d1,121d2 auf, welche vorteilhaft als Druckgussteile aus Zink- oder Aluminium ausgeführt sind. Jede weist wiederum eine separate Gruppe 121d3,121d4 von Ein- und Aushebelnasen auf. Vorteilhaft sind auf der Innenseite eines jeden Eingriffsteils 121d1,121d2 beispielhaft jeweils zwei Haltezapfen 121d9 angeformt. Mit Hilfe der Haltezapfen sind die Eingriffsteile 121d1,121d2 vorteilhaft mit einem dazugehörigen Griffteil 122d verbindbar. Das Griffteil 122d ist beispielhaft aus Kunststoff gefertigt und weist einen Stützblock 122d1 auf, der sich unterhalb des vorspringenden Griffkopfes 122d3 befindet. Auf beiden Seiten des Griffkopfes 122d3 ergeben sich ferner Auflageflächen 122d5 auf dessen Unterseite. Die kommen bei einer Montage auf die den Oberseiten von Auflagestegen 121d5,121d6 der Eingriffsteile 121d1,121d2 zu liegen. Desweiteren greifen dabei deren Haltezapfen 121d9 in entsprechende Aufnahmeöffnungen 122d2 im Stützblock 122d1 des Griffteils 122d ein

Figur 6 zeigt eine perspektivische Seitenansicht aller Teile von Figur 5 in einem zusammengefügten Zustand. Dabei kommt das Griffteil 122a des Betätigungshebels 12a auf dem Einund/oder Aushebelstück 121a zu liegen, während die Eingriffsteile 121d1,121d2 den Stützblock 122d1 umfassen. Schließlich weisen die Eingriffsteile 121d1,121d2 wiederum Bohrungen 121d7,121d8 für eine Drehwelle 13 auf.

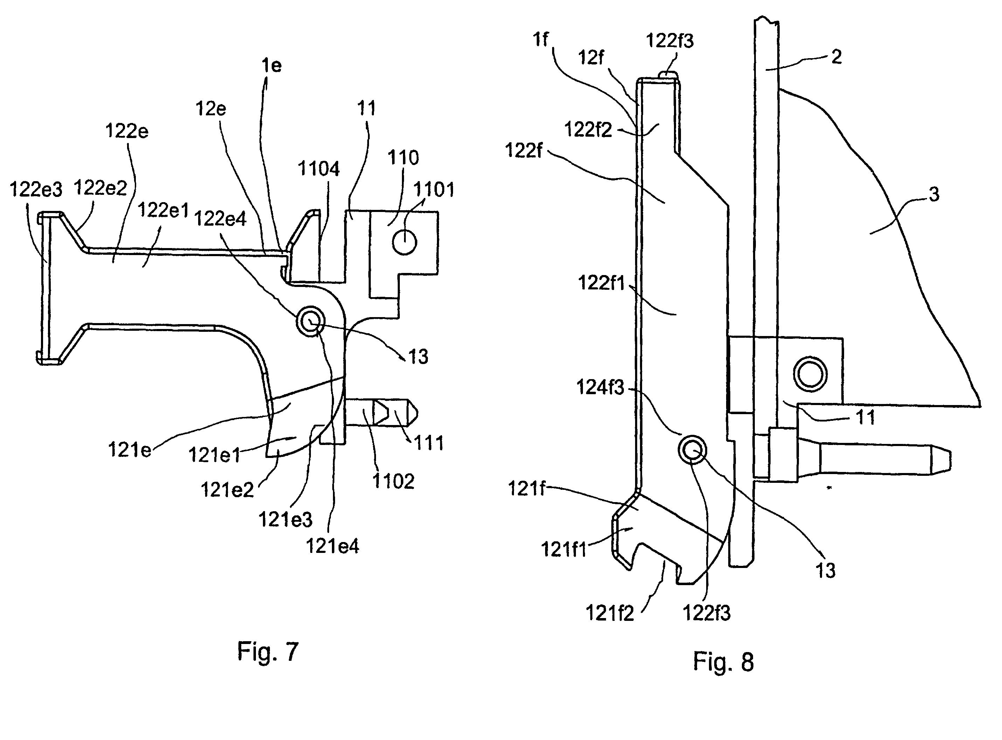

Figur 7 zeigt eine Seitenansicht auf eine weitere Ausführung eines erfindungsgemäßen Betätigungselementes 1e, wobei das beispielhaft aus Kunststoff bestehende Griffteil 122e des dazugehörigen Betätigungshebels 12e einen stark nach vorne ragenden Griffkopf 122e1 aufweist. Die linke Seite des Griffkopfes 122e1 endet in einem t-förmigen Frontteil 122e2, in das z.B. Beschriftungselemente 122e3 eingelegt werden können. Über eine Aufnahmebohrungen 122e4 im Griffteil 122e kann wiederum eine Drehwelle zur Halterung eines innen liegenden Einund/oder Aushebelstückes 121e aus einem verschleißfesten Material eingelegt sein. Dieses weist zumindest ein Eingriffsteil 121e1 auf, welches zur Bewirkung eines Einhebelvorganges über eine Einhebelnase 121e2 und zur Bewirkung eines Aushebelvorganges über einen Aushebelrücken 121e3 verfügt. Über eine Bohrung 121e4 kann eine Drehwelle 13 zur Verbindung mit dem Endstück 11 eingebracht werden. Dieses entspricht im wesentlichen dem am Beispiel der Figur 1 erläuterten Aufbau.

Figur 8 zeigt eine Seitenansicht auf eine weitere Ausführung eines Betätigungselementes 1f gemäß der Erfindung. Dabei weist der Betätigungshebel 12f ein Griffteil 122f mit einem hoch stehenden Griffkörper 122f1 und einer oben befindlichen, verjüngten Griffmulde 122f2 am Kopfende auf. Das wiederum vorteilhaft aus Kunststoff bestehende Griffteil 122f schmiegt sich bei dieser Ausführung in einer Raum sparenden Weise an eine dahinter liegenden Frontplatte 2 an. Bei dem in Figur 8 dargestellten Beispiel ist das Griffteil 122f ein Verriegelungselement 122f3 integriert, womit der Betätigungshebel 12f in der dargestellten Position verriegelt werden kann. Das Griffteil 122f des Betätigungshebels 12f ist mit einem Einund/oder Aushebelstück 121f verbunden, wobei diese Verbindung wiederum vorteilhaft über eine Drehwelle 13 erfolgt, welche über eine Bohrung 121f3 in das Griffteil 122f, das Einund/oder Aushebelstück 121f und das Endstück 11 eingeführt ist. Das Ein- und/oder Aushebelstück 121f weist zumindest ein Eingriffsteil 121f1 auf, das über eine Gruppe 121f2 von Einund Aushebelnasen verfügt. Zumindest diese Teile des Einund/oder Aushebelstück 121f bestehen aus einem verschleißfesten Material.

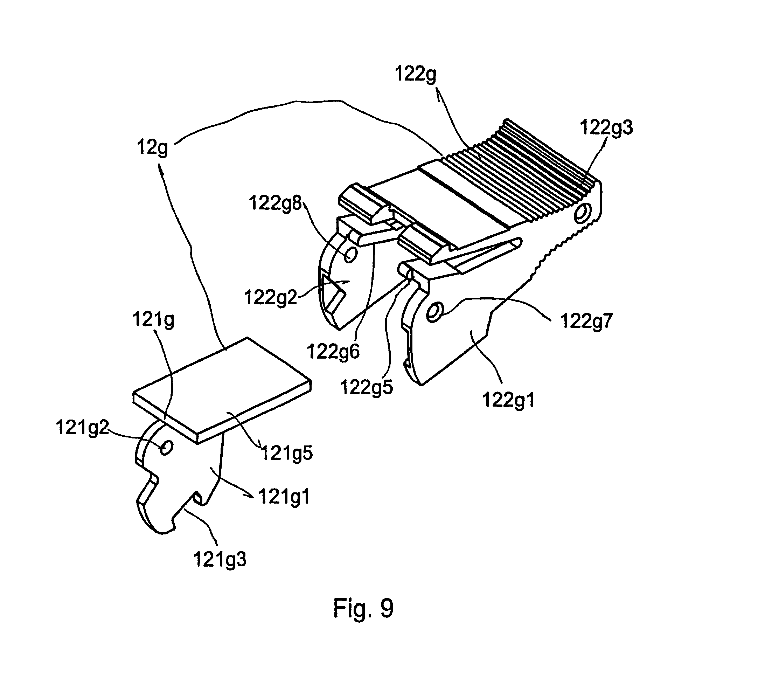

Figur 9 zeigt eine perspektivische Seitenansicht der wesentlichen Teile eines Betätigungshebels 12g für ein Betätigungselement gemäß der Erfindung in einer weiteren Ausführungsform. Das Ein- und Aushebelstück 121g weist dabei ein zentral angeordnetes Eingriffsteil 121g1 mit einer Gruppe 121g3 von Ein- und Aushebelnasen und einer t-förmig aufgesetzten Halteplatte 121g5 auf. Das Ein- und/oder Aushebelstück 121g ist beispielhaft als Zink- oder Aluminiumdruckgussteil ausgeführt. Über eine Bohrung 121a2 kann wiederum eine Drehwelle eingeführt werden. Das dazugehörige Griffteil 122g besteht beispielhaft aus Kunststoff und weist einen vorspringenden Griffkopf 122g3 mit seitlichen nach unten abgehenden Flanken 122g1,122g2 auf. Unterhalb des Griffkopfes 122g3 ergeben sich Auflageflächen 122g5,122g6 für die Halteplatte 121g5. Die Flanken 122g1,122g2 weisen Bohrungen 122g7,122g8 auf, in die eine Drehwelle eingeschoben werden kann, welche im montieren Zustand auch die Bohrung 121g2 in dem dazwischen liegenden Eingriffsteil 121g1 durchdringt.

## Patentansprüche

1. Betätigungselement (1) zum Ein- undloder Aushebeln einer Flachbaugruppe (3), **gekennzeichnet durch**
a) ein Endstück (11), welches zur Verbindung mit einer Flachbaugruppe (3) vorbereitet ist, und
b) einen Betätigungshebel (12; 12a; 12b; 12c; 12d; 12e; 12f; 12g), der drehbar am Endstück (11) gelagert ist und aufweist
b1) ein Griffteil (122; 122a; 122b; 122c; 122d; 122e; 122f; 122g) und
b2) ein Ein- und/oder Aushebelstück (121, 121a; 121b; 121c; 121d; 121e; 121f; 121g), welches ein Eingriffsteil (121a1, 121a2) mit einer Einhebelnase (1210) und/oder ein Eingriffsteil (121a1, 121a2) mit einer Aushebelnase (1211) aufweist, und
dass die Einhebelnase (1210) und/oder die Aushebelnase (1211) aus einem verschleißfesteren Material als das Griffteil besteht.

2. Betätigungselement (1) nach Anspruch 1, **dadurch gekennzeichnet , dass** ein Ein- und/oder Aushebelstück (121;121a;121b;121c;121d;121e;121f;121g) ein Eingriffsteil (121a1,121a2) mit einer Einhebelnase (1210) aus einem verschleißfesten Material aufweist.

3. Betätigungselement (1) nach Anspruch 1 oder 2, **dadurch gekennzeichnet , dass** ein Ein- und/oder Aushebelstück (121;121a;121b;121c;121d;121e;121f;121g) ein Eingriffsteil (121a1,121a2) mit einer Aushebelnase (1211) aus einem verschleißfesten Material aufweist.

4. Betätigungselement (1) nach Anspruch 2 oder 3, **dadurch gekennzeichnet , dass** ein Ein- und/oder Aushebelstück (121a;121c) zwei nebeneinander angeordnete Eingriffsteile (121a1,121a2;121c1,121c2) aufweist.

5. Betätigungselement (1) nach Anspruch 4, **dadurch gekennzeichnet, dass** die beiden nebeneinander angeordneten Eingriffsteile (121a1,121a2;121b1,121b2) über ein Verbindungsteil (121a5;121b5) einstückig miteinander verbunden sind.

6. Betätigungselement (1) nach einem der Ansprüche 2 bis 5, **dadurch gekennzeichnet , dass** das Griffteil (122c) Haltemittel (122c5,122c6) zur Halterung mindestens eines Eingriffsteils (121c1,121c2) aufweist (Figur 4).

7. Betätigungselement (1) nach einem der vorangegangenen Ansprüche 2 bis 5, **dadurch gekennzeichnet , dass** an mindestens einem Eingriffsteil (121d1,121d2) mindestens ein Haltezapfen (121d9) angeformt ist, und das Griffteil (122d) mindestens eine Aufnahmeöffnung (122d2) für den mindestens einen Haltezapfen (121d9) aufweist (Figuren 5 und 6).

8. Betätigungselement (1) nach einem der vorangegangenen Ansprüche, **dadurch gekennzeichnet , dass** das Ein- und/oder Aushebelstück (121a;121d;121e;121f) ein Druckgussteil ist, insbesondere aus Aluminium und/oder Zink.

9. Betätigungselement (1) nach einem der Ansprüche 1 bis 7, **dadurch gekennzeichnet , dass** das Ein- und/oder Aushebelstück (121c) ein Stanzteil insbesondere aus Blech ist.

10. Betätigungselement (1) nach einem der Ansprüche 1 bis 7, **dadurch gekennzeichnet , dass** das Ein- und/oder Aushebelstück (121b;121g) ein Stanzbiegeteil insbesondere aus Blech ist.

11. Betätigungselement (1) nach einem der vorangegangenen Ansprüche, **dadurch gekennzeichnet , dass** das Griffteil (122a) des Betätigungshebels (12a) mindestens eine seitliche Flanke (122a1,122a2) aufweist, welche das Einund/oder Aushebelstück (121a) umfasst.

12. Betätigungselement (1) nach einem der vorangegangenen Ansprüche, **dadurch gekennzeichnet , dass** das Ein- und/oder Aushebelstück (121a) des Betätigungshebels (12a) in das Griffteil (122a) eingelegt ist (Figuren 2 und 3).

13. Betätigungselement (1) nach einem der Ansprüche 1 bis 11, **dadurch gekennzeichnet , dass** das Griffteil (122a) des Betätigungshebels (12a) auf dem Ein- und/oder Aushebelstück (121a) aufliegt (Figuren 5 und 6).

14. Betätigungselement (1) nach einem der vorangegangenen Ansprüche, **dadurch gekennzeichnet , dass** das Griffteil (122) des Betätigungshebels (12) Verrastmittel (1222) aufweist.

15. Betätigungselement (1) nach einem der vorangegangenen Ansprüche, **dadurch gekennzeichnet , dass** das Griffteil (122) des Betätigungshebels (12) aus einem ergonomisch gut formbaren Material besteht, insbesondere aus Kunststoff.

16. Betätigungselement (1) nach einem der vorangegangenen Ansprüche, **dadurch gekennzeichnet , dass** das Griffteil (122) des Betätigungshebels (12) aus einem elastischen Material besteht, insbesondere aus Gummi.

17. Betätigungselement (1) nach einem der vorangegangenen Ansprüche, **dadurch gekennzeichnet , dass** das Endstück (11), das Ein- und/oder Aushebelstück (121;121a) und das Griffteil (122;122a) des Betätigungshebels (12;12a) jeweils eine Bohrung (1105;1212,1223;121a7;122a5) aufweisen und über eine darin eingelegte Drehwelle (13) miteinander verbunden sind.

18. Betätigungselement (1) nach einem der vorangegangenen Ansprüche 1 bis 14, **dadurch gekennzeichnet , dass** das Griffteil (122) und das Ein- und/oder Aushebelstück (121) des Betätigungshebels (12) nichtlösbar miteinander verbunden sind.

19. Betätigungselement (1) nach Anspruch 18, **dadurch gekennzeichnet , dass** das Griffteil (122) einstückig an das Ein- und/oder Aushebelstück angeformt ist, insbesondere angespritzt ist.

20. Verfahren zur Herstellung eines Betätigungselements (1) nach Anspruch 18 oder 19, **dadurch gekennzeichnet, dass** das Griffteil (122) einstückig an das Einund/oder Aushebelstück angeformt wird, insbesondere angespritzt wird.

21. Frontsystem für eine Flachbaugruppe (3), welches aufweist eine Frontplatte (2) und mindestens ein Betätigungselement (1) nach einem der vorangegangenen Ansprüche 1 bis 19, das an einem Ende (20) der Frontplatte (2) angebracht ist.

22. Flachbaugruppe mit einem Frontsystem nach Anspruch 21.

23. Baugruppenträger (4), welcher so gestaltet ist, dass Flachbaugruppen (3), die ein Frontsystem nach Anspruch 21 aufweisen, ein- und/oder aushebelbar sind.

## Claims

1. Actuating element (1) for levering a printed circuit board (3) in and/or out, **characterized by**
a) an end piece (11), which is prepared for connection to a printed circuit board (3), and
b) an actuating lever (12; 12a; 12b; 12c; 12d; 12e; 12f; 12g) which is mounted in a rotatable manner on the end piece (11) and has
b1) a grip part (122; 122a; 122b; 122c; 122d; 122e; 122f; 122g) and
b2) a levering-in and/or levering-out member (121, 121a; 121b; 121c; 121d; 121e; 121f; 121g), which has an engagement part (121a1, 121a2) with a levering-in nose (1210) and/or an engagement part (121a1, 121a2) with a levering-out nose (1211), and
in that the levering-in nose (1210) and/or the levering-out nose (1211) consist/consists of a more wear-resistant material than the grip part.

2. Actuating element (1) according to Claim 1, **characterized in that** a levering-in and/or levering-out member (121; 121a; 121b; 121c; 121d; 121e; 121f; 121g) have/has an engagement part (121a1, 121a2) with a levering-in nose (1210) made of a wear-resistant material.

3. Actuating element (1) according to Claim 1 or 2, **characterized in that** a levering-in and/or levering-out member (121; 121a; 121b; 121c; 121d; 121e; 121f; 121g) have/has an engagement part (121a1, 121a2) with a levering-out nose (1211) made of a wear-resistant material.

4. Actuating element (1) according to Claim 2 or 3, **characterized in that** a levering-in and/or levering-out member (121a; 121c) have/has two engagement parts (121a1, 121a2; 121c1, 121c2) arranged one beside the other.

5. Actuating element (1) according to Claim 4, **characterized in that** the two engagement parts (121a1, 121a2; 121b1, 121b2) arranged one beside the other are connected integrally to one another via a connecting part (121a5; 121b5).

6. Actuating element (1) according to one of Claims 2 to 5, **characterized in that** the grip part (122c) has retaining means (122c5, 122c6) for securing at least one engagement part (121c1, 121c2) (Figure 4).

7. Actuating element (1) according to one of the preceding Claims 2 to 5, **characterized in that** at least one retaining pin (121d9) is integrally formed on at least one engagement part (121d1, 121d2), and the grip part (122d) has at least one accommodating opening (122d2) for at least one retaining pin (121d9) (Figures 5 and 6).

8. Actuating element (1) according to one of the preceding claims, **characterized in that** the levering-in and/or levering-out member (121a; 121d; 121e; 121f) is a die casting, in particular made of aluminium and/or zinc.

9. Actuating element (1) according to one of Claims 1 to 7, **characterized in that** the levering-in and/or levering-out member (121c) is a punched part in particular made of sheet metal.

10. Actuating element (1) according to one of Claims 1 to 7, **characterized in that** the levering-in and/or levering-out member (121b, 121g) is a punched and bent part in particular made of sheet metal.

11. Actuating element (1) according to one of the preceding claims, **characterized in that** the grip part (122a) of the actuating lever (12a) has at least one lateral flank (122a1, 122a2) which encloses the levering-in and/or levering-out member (121a).

12. Actuating element (1) according to one of the preceding claims, **characterized in that** the levering-in and/or levering-out member (121a) of the actuating lever (12a) is positioned in the grip part (122a) (Figures 2 and 3).

13. Actuating element (1) according to one of Claims 1 to 11, **characterized in that** the grip part (122a) of the actuating lever (12a) rests on the levering-in and/or levering-out member (121a) (Figures 5 and 6).

14. Actuating element (1) according to one of the preceding claims, **characterized in that** the grip part (122) of the actuating lever (12) has latching means (1222).

15. Actuating element (1) according to one of the preceding claims, **characterized in that** the grip part (122) of the actuating element (12) consists of a material which lends itself well to ergonomic shaping, in particular of plastic.

16. Actuating element (1) according to one of the preceding claims, **characterized in that** the grip part (122) of the actuating lever (12) consists of an elastic material, in particular of rubber.

17. Actuating element (1) according to one of the preceding claims, **characterized in that** the end piece (11), the levering-in and/or levering-out member (121; 121a) and the grip part (122; 122a) of the actuating lever (12; 12a) each have a bore (1105; 1212, 1223; 121a7; 122a5) and are connected to one another via a rotary shaft (13) positioned therein.

18. Actuating element (1) according to one of the preceding Claims 1 to 14, **characterized in that** the grip part (122) and the levering-in and/or levering-out member (121) of the actuating lever (12) are connected to one another in a non-releasable manner.

19. Actuating element (1) according to Claim 18, **characterized in that** the grip part (122) is integrally formed, in particular injection moulded, on the levering-in and/or levering-out member.

20. Process for producing an actuating element (1) according to Claim 18 or 19, **characterized in that** the grip part (122) is integrally formed, in particular injection moulded, on the levering-in and/or levering-out member.

21. Front system for a printed circuit board (3), which has a front panel (2) and at least one actuating element (1) according to one of the preceding Claims 1 to 19, which is fitted at one end (20) of the front panel (2).

22. Printed circuit board with a front system according to Claim 21.

23. Mounting rack (4) which is configured such that printed circuit boards (3) which have a front system according to Claim 21 can be levered in and/or out.

## Revendications

1. Elément d'actionnement (1) pour l'introduction et/ou le retrait d'une carte de circuits imprimés (3), **caractérisé par**
a) une pièce d'extrémité (11), qui est préparée pour être reliée à une carte de circuits imprimés (3) et
b) un levier d'actionnement (12 ; 12a ; 12b ; 12c ; 12d ; 12e ; 12f ; 12g), qui est monté de façon pivotante sur la pièce d'extrémité (11) et présente
b1) une partie poignée (122 ; 122a ; 122b ; 122c ; 122d ; 122e ; 122f ; 122g) et
b2) un levier d'introduction et/ou de retrait (121 ; 121a ; 121b ; 121c ; 121d ; 121e ; 121f ; 121g), qui présente une partie d'engrènement (121a1, 121a2) avec un ergot d'introduction (1210) et/ou une partie d'engrènement (121a1, 121a2) avec un ergot de retrait (1211), et
en ce que l'ergot d'introduction (1210) et/ou l'ergot de retrait (1211) est à base d'un matériau plus résistant à l'usure que la partie poignée.

2. Elément d'actionnement (1) selon la revendication 1, **caractérisé en ce qu'**un levier d'introduction et/ou de retrait (121 ; 121a ; 121b ; 121c ; 121d ; 121e ; 121f ; 121g) présente une partie d'engrènement (121a1, 121a2) avec un ergot d'introduction (1210) à base d'un matériau résistant à l'usure.

3. Elément d'actionnement (1) selon la revendication 1 ou 2, **caractérisé en ce qu'**un levier d'introduction et/ou de retrait (121 ; 121a ; 121b ; 121c ; 121d ; 121e ; 121f ; 121g) présente une partie d'engrènement (121a1, 121a2) avec un ergot de retrait (1211) à base d'un matériau résistant à l'usure.

4. Elément d'actionnement (1) selon la revendication 2 ou 3, **caractérisé en ce qu'**un levier d'introduction et/ou de retrait (121a ; 121c) présente deux parties d'engrènement (121a1, 121a2 ; 121c1, 121c2) disposées l'une à côté de l'autre.

5. Elément d'actionnement (1) selon la revendication 4, **caractérisé en ce que** les deux parties d'engrènement (121a1, 121a2 ; 121b1, 121b2) disposées l'une à côté de l'autre sont reliées d'un seul tenant par une pièce de liaison (121a5 ; 121b5).

6. Elément d'actionnement (1) selon l'une quelconque des revendications 2 à 5, **caractérisé en ce que** la partie poignée (122c) présente des moyens de retenue (122c5, 122c6) pour la retenue d'au moins une partie d'engrènement (121c1, 121c2) (figure 4).

7. Elément d'actionnement (1) selon l'une quelconque des revendications précédentes 2 à 5, **caractérisé en ce qu'**au moins un tourillon de retenue (121d9) est formé sur au moins une partie d'engrènement (121d1, 121d2) et la partie poignée (122d) présente au moins un orifice de logement (122d2) pour le au moins un tourillon de retenue (121d9) (figures 5 et 6).

8. Elément d'actionnement (1) selon l'une quelconque des revendications précédentes, **caractérisé en ce que** le levier d'introduction et/ou de retrait (121a ; 121d ; 121e ; 121f) est une partie coulée sous pression, en particulier à base d'aluminium et/ou de zinc.

9. Elément d'actionnement (1) selon l'une quelconque des revendications 1 à 7, **caractérisé en ce que** le levier d'introduction et/ou de retrait (121c) est une pièce découpée, en particulier à base de tôle.

10. Elément d'actionnement (1) selon l'une quelconque des revendications 1 à 7, **caractérisé en ce que** le levier d'introduction et/ou de retrait (121b ; 121g) est une pièce découpée et pliée, en particulier à base de tôle.

11. Elément d'actionnement (1) selon l'une quelconque des revendications précédentes, **caractérisé en ce que** la partie poignée (122a) du levier d'actionnement (12a) présente au moins un flan latéral (122a1, 122a2), qui comprend le levier d'introduction et/ou de retrait (121a).

12. Elément d'actionnement (1) selon l'une quelconque des revendications précédentes, **caractérisé en ce que** le levier d'introduction et/ou de retrait (121a) du levier d'actionnement (12a) est introduit dans la partie poignée (122a) (figures 2 et 3).

13. Elément d'actionnement (1) selon l'une quelconque des revendications 1 à 11, **caractérisé en ce que** la partie poignée (122a) du levier d'actionnement (12a) repose sur le levier d'introduction et/ou de retrait (121a) (figures 5 et 6).

14. Elément d'actionnement (1) selon l'une quelconque des revendications précédentes, **caractérisé en ce que** la partie poignée (122) du levier d'actionnement (12) présente des moyens d'enclenchement (1222).

15. Elément d'actionnement (1) selon l'une quelconque des revendications précédentes, **caractérisé en ce que** la partie poignée (122) du levier d'actionnement (12) est à base d'un matériau bien façonnable au plan ergonomique, en particulier à base de plastique.

16. Elément d'actionnement (1) selon l'une quelconque des revendications précédentes, **caractérisé en ce que** la partie poignée (122) du levier d'actionnement (12) est à base d'un matériau élastique, en particulier à base de caoutchouc.

17. Elément d'actionnement (1) selon l'une quelconque des revendications précédentes, **caractérisé en ce que** la pièce d'extrémité (11), le levier d'introduction et/ou de retrait (121 ; 121a) et la partie poignée (122 ; 122a) du levier d'actionnement (12 ; 12a) présentent chacun un alésage (1105 ; 1212, 1223 ; 121a7 ; 122a5) et sont reliés entre eux au moyen d'un arbre de rotation (13) introduit à l'intérieur.

18. Elément d'actionnement (1) selon l'une quelconque des revendications précédentes 1 à 14, **caractérisé en ce que** la partie poignée (122) et le levier d'introduction et/ou de retrait (121) du levier d'actionnement (12) sont reliés entre eux de façon non amovible.

19. Elément d'actionnement (1) selon la revendication 18, **caractérisé en ce que** la partie poignée (122) est formée, en particulier injectée, d'un seul tenant sur le levier d'introduction et/ou de retrait.

20. Procédé pour la fabrication d'un élément d'actionnement (1) selon la revendication 18 ou 19, **caractérisé en ce que** la partie poignée (122) est formée, en particulier injectée, d'un seul tenant sur le levier d'introduction et/ou de retrait.

21. Système de façade pour une carte de circuits imprimés (3), qui présente une plaque frontale (2) et au moins un élément d'actionnement (1) selon l'une quelconque des revendications précédentes 1 à 19, lequel est appliqué sur une extrémité (20) de la plaque frontale (2).

22. Carte de circuits imprimés avec un système de façade selon la revendication 21.

23. Support d'ensemble (4), qui est conçu de telle sorte que des cartes de circuits imprimés (3), qui présentent un système de façade selon la revendication 21, peuvent être introduites et/ou retirées.
